# EUROPÄISCHE PATENTSCHRIFT

(11) **EP 1 721 387 B1**
(45) Veröffentlichungstag und Bekanntmachung des Hinweises auf die Patenterteilung: **08.08.2018**
(21) Anmeldenummer: 05715718.2
(22) Anmeldetag: 04.03.2005
(51) Int. Cl.: H03K 17/082

(54) **ELEKTRISCHE SCHALTUNGSANORDNUNG FÜR EIN ELEKTROWERKZEUG**
ELECTRICAL CIRCUIT ARRANGEMENT FOR A POWER TOOL
CIRCUIT ÉLECTRIQUE POUR OUTIL ÉLECTRIQUE

(30) Priorität: 05.03.2004 DE 102004010737
(43) Veröffentlichungstag der Anmeldung: 15.11.2006
(73) Patentinhaber: Marquardt GmbH, 78604 Rietheim-Weilheim (DE)
(72) Erfinder: BROGHAMMER, Peter, 78573 Wurmlingen (DE)
(74) Vertreter: Otten, Roth, Dobler & Partner mbB Patentanwälte
(86) Internationale Anmeldenummer: PCT/EP2005/002276
(87) Internationale Veröffentlichungsnummer: WO 2005/086349

(56) Entgegenhaltungen:
- WO-A-02/078029
- US-A1- 2002 097 541
- 4. Februar 2004 (2004-02-04), , XP002336376 Gefunden im Internet: URL:http://www.ferromel.de/tronic_143.htm> das ganze Dokument

## Beschreibung

Die Erfindung betrifft einen elektrischen Schalter für ein Elektrowerkzeug nach dem Oberbegriff des Patentanspruchs 1.

Solche elektrische Schaltungsanordnungen dienen zur Steuerung und/oder Regelung der abgegebenen Leistung einer Last. Bei der Last handelt es sich um einen Elektromotor für das Elektrowerkzeug, so daß die Schaltungsanordnung zur Steuerung und/oder Regelung von dessen Drehzahl und/oder Drehmoment dient.

Eine derartige elektrische Schaltungsanordnung besteht aus elektrischen und/oder elektronischen Bauelementen. Unter den Bauelementen befindet sich wenigstens ein wärmeerzeugendes Leistungsbauteil, wie ein Leistungstransistor, ein MOS-FET, ein Triac o. dgl., das zur eigentlichen Steuerung und/oder Regelung der Leistung der Last dient. Dies kann durch entsprechende Steuerung und/oder Regelung des durch das Leistungsbauteil zur Last fließenden elektrischen Laststroms geschehen. Eine solche in einem Schalter für ein Elektrowerkzeug, und zwar für ein Akku-Elektrowerkzeug, untergebrachte Schaltungsanordnung ist beispielsweise in der DE 41 14 854 A1 gezeigt. Des Weiteren zeigt auch die WO 02/078029 A1 eine derartige elektrische Schaltungsanordnung, die auf einer im elektrischen Schalter befindlichen Leiterplatte angeordnet ist.

Während des Betriebs der elektrischen Schaltungsanordnung wird Wärme in den Bauelementen, und zwar vor allem im Leistungsbauteil, erzeugt. Diese Verlustwärme muss abgeführt werden, um thermische Beschädigungen der Bauelemente und dadurch eine Zerstörung der Schaltungsanordnung zu verhindern. Es hat sich herausgestellt, dass dies nicht immer im gewünschten Maße möglich ist. Insbesondere bei elektrischen Schaltern für Elektrowerkzeuge mit großer Leistung, bei denen eine Schaltungsanordnung zur Drehzahlsteuerung, zur Drehmomentabschaltung o. dgl. im weitgehend abgeschlossenen Gehäuse des Schalters angeordnet ist, haben sich entsprechende Beeinträchtigungen bis hin zum vorzeitigen Ausfall des Schalters ergeben. Vor allem ist dieses Problem bei Akku-Elektrowerkzeugen relevant, wo hohe Ströme durch den Schalter fließen.

In der US 2002/097541 A1 ist eine Leistungsschaltung mit einer Schutzfunktion vor thermischer Zerstörung beschrieben. Hierzu besitzt die Leistungsschaltung einen Thermosensor, dessen in Abhängigkeit von der Temperatur der Leistungsschaltung stehendes Signal ein Leistungsbauteil mittels einer Pulsweiten-Modulation derart ansteuert, dass der Laststrom durch das Leistungsbauteil entsprechend begrenzt wird. Einen Hinweis zur Verwendung einer solchen Leistungselektronik in einem elektrischen Schalter für ein Elektrowerkzeug gibt dieses Dokument nicht. Des Weiteren bleibt die nähere Anordnung des Thermosensors offen.

Der Erfindung liegt die Aufgabe zugrunde, die im elektrischen Schalter für ein Elektrowerkzeug befindliche elektrische Schaltungsanordnung auch bei ungenügender Wärmeabfuhr vor einer Zerstörung durch Überhitzung zu schützen.

Diese Aufgabe wird bei einem gattungsgemäßen elektrischen Schalter durch die kennzeichnenden Merkmale des Anspruchs 1 gelöst.

Der erfindungsgemäße elektrische Schalter besitzt ein Mittel zur Überwachung der Temperatur der Schaltungsanordnung. Vorteilhafterweise ist das Mittel zur Überwachung der Temperatur als ein temperaturabhängiges Bauteil in der Art eines Sensors für die Temperatur in der Schaltungsanordnung selbst angeordnet, wodurch eine direkte thermische Anbindung des Sensors in den Schaltkreis und somit an die Wärmequelle gegeben ist. Um eine gute sowie direkte Wärmekopplung zum Leistungsbauteil zu erreichen, ist das temperturabhängige Bauteil auf der Leiterplatte angeordnet. Das Mittel zur Überwachung der Temperatur bewirkt bei Erreichen einer Grenz-Temperatur die Reduzierung der Leistung der Last mit Hilfe des Leistungsbauteils durch Reduzierung des durch das Leistungsbauteil fließenden Laststroms. Die Reduzierung der Leistung der Last setzt also dann ein, wenn die Temperatur innerhalb der Schaltungsanordnung über einen definierten Wert ansteigt, so dass einer Überhitzung sowie Zerstörung der Schaltungsanordnung wirksam vorgebeugt wird. Zweckmäßigerweise wird die Leistung der Last soweit reduziert, dass die Grenztemperatur anschließend wieder unterschritten wird. Weitere Ausgestaltungen der Erfindung sind Gegenstand der Unteransprüche.

Üblicherweise ist die Schaltungsanordnung auf einer Leiterplatte angeordnet. Um eine besonders gute Wärmeabführung als flankierende Maßnahme zu erzielen, bietet sich als Leiterplatte eine IMS(Insulated Metal Substrate)-Leiterplatte an, die über eine ausgezeichnete Wärmeleitfähigkeit verfügt.

Insbesondere bietet sich als temperaturabhängiges Bauteil ein NTC-Widerstand an. In einfacher und kostengünstiger Art und Weise kann der NTC-Widerstand mittels Widerstandsdruck auf die Leiterplatte aufgebracht sein. Je nach dem, ob der Überlastschutz benötigt wird, kann vorteilhafterweise dann der NTC-Widerstand oder auch ein normaler Widerstand auf das einheitliche Layout der Leiterplatte bestückt werden. Somit kann die Schaltungsanordnung bei allenfalls geringfügigen Mehraufwand in Varianten mit und ohne Überlastschutz hergestellt werden.

Wird der Elektromotor mittels Gleichspannung betrieben, so lässt sich die Schaltungsanordnung als Pulsweiten-Modulations(PWM)-Schaltung ausbilden. Zur Reduzierung der Leistung der Last bietet es sich dann in einfacher Art an, das Tastverhältnis der PWM-Schaltung zu verkleinern. Üblicherweise weist die PWM-Schaltung einen Timer-Baustein mit einem internen Spannungsteiler auf. Unter lediglich geringem Aufwand kann dann der NTC-Widerstand an den internen Spannungsteiler angeschaltet sein, um das Tastverhältnis in der gewünschten Weise bei Erhöhung der Temperatur am internen Spannungsteiler zu manipulieren.

Wird der Elektromotor mittels Wechselspannung betrieben, so lässt sich die Schaltungsanordnung als Phasenanschnitt- und/oder Phasenabschnitt-Steuerungsschaltung ausbilden. Zur Reduzierung der Leistung der Last bietet es sich dann in einfacher Art an, den Phasenanschnitt und/oder Phasenabschnitt entsprechend zu verkleinern.

Die Erfindung lässt sich besonders vorteilhaft bei einem elektrischen Schalter für ein Elektrowerkzeug, wie für ein Akku- und/oder Netz-Elektrowerkzeug, einsetzen. Ein solcher Elektrowerkzeugschalter besitzt eine in der Art einer Leistungselektronik ausgebildete Schaltungsanordnung zur Drehzahlsteuerung und/oder Drehzahlregelung des Elektromotors für das Elektrowerkzeug, wobei die Leistungselektronik der Kompaktheit halber häufig im Gehäuse des Elektrowerkzeugschalters befindlich ist. Wird das Elektrowerkzeug zu lange mittels der Leistungselektronik betrieben, so kann die Leistungselektronik bei nicht ausreichender Wärmeabfuhr überhitzen und zerstört werden. Um einer Überhitzung der Elektronik vorzubeugen, ist der Elektrowerkzeugschalter mit einer Temperaturüberwachung versehen und erfindungsgemäß wird bei Erreichen einer vorgegebenen Grenztemperatur der Schaltungsanordnung im Elektrowerkzeugschalter eine Drehzahlabsenkung vorgenommen, so daß die Leistungselektronik im Elektrowerkzeugschalter wirksam vor Überhitzung geschützt ist.

Gegebenenfalls wird in diesem Fall der Anwender den Elektrowerkzeugschalter vollständig betätigen, um wieder die gewünschte beziehungsweise erforderliche Leistung des Elektrowerkzeugs zu erhalten. Dann schaltet jedoch der in der Regel vorgesehene Überbrückungskontakt im Schalter ein, wodurch die Leistungselektronik überbrückt wird und die volle Spannung am nunmehr ungeregelt betriebenen Elektromotor anliegt. Da die überbrückte Leistungselektronik in diesem Fall außer Betrieb ist, kann diese dann wiederum abkühlen. Folglich wird der Anwender automatisch gezwungen, falls er eine nicht reduzierte sondern im wesentlichen gleichbleibende Leistung des Elektrowerkzeugs wünscht, die Leistungselektronik zu überbrücken, was letztendlich dann deren Schutz bewirkt.

Die mit der Erfindung erzielten Vorteile bestehen insbesondere darin, daß sich ein geschlossener Regelkreis zum Schutz der Schaltungsanordnung, insbesondere der Leistungselektronik in einem Elektrowerkzeugschalter, vor Überhitzung ergibt. Dennoch handelt es sich um eine einfache sowie kostengünstige Realisierung für diese Überlastschaltung. Desweiteren ist die Verwendung schwächerer, und damit preisgünstigerer Leistungsbauteile aufgrund der erfindungsgemäß erreichten Schutzfunktion gegeben.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: einen elektrischen Schalter in Seitenansicht,
- Fig. 2: einen Schnitt entlang der Linie 2-2 in Fig. 1 und
- Fig. 3: einen Schaltplan für eine als Pulsweiten-Modulations-Schaltung ausgebildete Schaltungsanordnung.

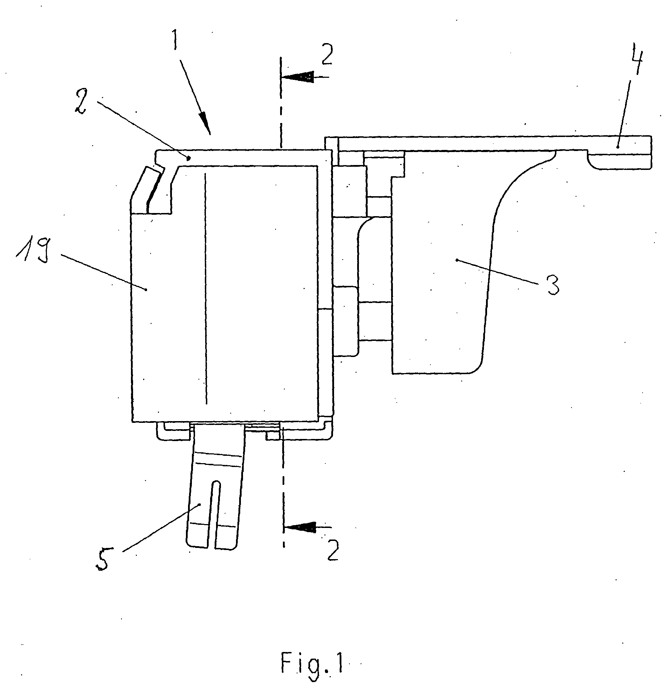

In Fig. 1 ist ein elektrischer Schalter 1 zu sehen, der für ein Elektrowerkzeug mit Elektromotor, und zwar insbesondere für ein mit Gleichspannung betriebenes Akku-Elektrowerkzeug zu verwenden ist. Der Schalter 1 besitzt ein Gehäuse 2, ein in der Art eines Drückers ausgebildetes, am Gehäuse 2 beweglich angeordnetes Betätigungsorgan 3 für die manuelle Betätigung des Elektrowerkzeugs durch den Benutzer, ein in der Art eines Umschalthebels ausgebildetes Betätigungselement 4 zur Umschaltung des Rechts-Links-Laufs für das Elektrowerkzeug sowie am Gehäuse 2 angeordnete Anschlußklemmen 5 zur elektrischen Verbindung mit dem Akku. Selbstverständlich kann ein solcher Schalter 1 bei entsprechender Ausgestaltung, was nachfolgend noch kurz verdeutlicht wird, auch für ein mit Wechselspannung betriebenes Netz-Elektrowerkzeug verwendet werden.

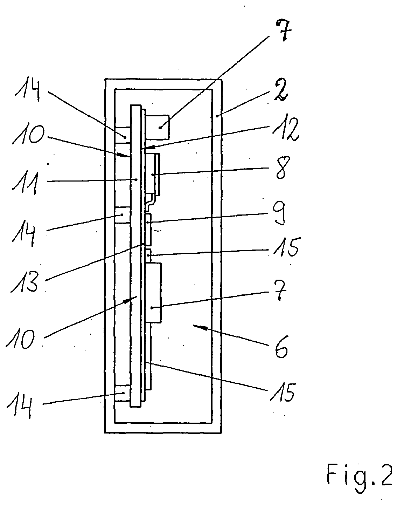

Wie weiter in Fig. 2 schematisch dargestellt ist, ist im Gehäuse 2 eine in der Art einer Leistungselektronik ausgebildete elektrische Schaltungsanordnung 6 zur Steuerung und/oder Regelung der Drehzahl des als Last wirkenden Elektromotors im Elektrowerkzeug angeordnet. Die Schaltungsanordnung 6 kann auch eine Steuerung des Drehmoments, vorzugsweise zur Drehmomentabschaltung des Elektromotors, die beispielsweise für Schraubarbeiten mit dem Elektrowerkzeug verwendbar ist, oder eine sonstige Funktionalität des Elektrowerkzeugs beinhalten. Die Schaltungsanordnung 6 enthält damit zumindest einen Teil der Steuerelektronik für den Elektromotor des Elektrowerkzeugs. Das Gehäuse 2 nimmt in bekannter Weise noch weitere Teile des Schalters 1 auf, wie das Kontaktsystem o. dgl., was jedoch nicht weiter gezeigt ist.

Die Schaltungsanordnung 6 weist elektrische und/oder elektronische Bauelemente 7 auf. Darunter befindet sich auch wenigstens ein Leistungsbauteil 8, bei dessen Betrieb Verlustwärme erzeugt wird. Bei dem Leistungsbauteil 8 handelt es sich um einen Leistungstransistor oder um einen MOS-FET zur Steuerung und/oder Regelung der Leistung der Last. Diese Steuerung und/oder Regelung erfolgt üblicherweise durch entsprechende Steuerung und/oder Regelung des durch das Leistungsbauteil 8 zur Last fließenden elektrischen Laststroms. In der Schaltungsanordnung 6 ist ein Mittel 9 zur Überwachung der Temperatur vorhanden, derart daß das Mittel 9 zur Überwachung der Temperatur bei Erreichen einer voreingestellten Grenz-Temperatur die Leistung der Last mit Hilfe des Leistungsbauteils 8 reduziert. Zweckmäßigerweise geschieht dies durch Reduzierung des durch das Leistungsbauteil 8 fließenden Laststroms. Bevorzugterweise wird die Leistung der Last soweit reduziert, daß die Grenztemperatur anschließend wieder unterschritten wird. Folglich wird bei Erreichen der Grenztemperatur der Schaltungsanordnung 6 also eine Drehzahlabsenkung des Elektromotors im Elektrowerkzeug vorgenommen. Somit ist eine unzulässige Erwärmung der Schaltungsanordnung 6 mit Sicherheit vermieden. Zur Verhinderung von Drehzahlschwankungen im kritischen Bereich der Grenz-Temperatur läßt sich die Drehzahlanpassung mit einer Art von Hysterese vornehmen.

Wie weiter der Fig. 2 zu entnehmen ist, ist die Schaltungsanordnung 6 auf einer Leiterplatte 10 angeordnet. Die Leiterplatte 10 kann in der Art einer IMS(Insulated Metal Substrate)-Leiterplatte ausgestaltet sein, welche besonders gute wärmeleitende Eigenschaften besitzt. Eine solche IMS-Leiterplatte besteht aus einem Metallteil 11, an dessen den Bauelementen 7 zugewandten Oberfläche 12 eine elektrisch isolierende Beschichtung 13 befindlich ist. Auf der Beschichtung 13 sind in bekannter Weise die Leiterbahnen 15 zur elektrischen Verbindung der Bauelemente 7 aufgebracht. Die Leiterplatte 10 ist mittels Halterungen 14 im Gehäuse 2 befestigt. Zur Verbesserung der Wärmeabfuhr aus dem Gehäuse 2 kann die Leiterplatte 10 in bekannter Weise mit einem beispielsweise außen am Gehäuse 2 befestigten Kühlkörper 19 (siehe Fig. 1) verbunden sein.

Das Mittel 9 zur Überwachung der Temperatur weist ein temperaturabhängiges Bauteil auf, das auf der Leiterplatte 10 mit direkter Wärmekopplung zum Leistungsbauteil 8 angeordnet ist. Hierzu befindet sich das temperaturabhängige Bauteil 9 in unmittelbarer Nähe zum Leistungsbauteil 8, wie der Fig. 2 zu entnehmen ist, so daß das temperaturabhängige Bauteil 9 die Temperatur des Leistungsbauteils 8 weitgehend unverfälscht detektiert. Bei einer IMS-Leiterplatte 10 sorgt das Metallteil 11 für eine gute Wärmekopplung, so daß das temperaturabhängige Bauteil 9 durchaus auch entfernt vom Leistungsbauteil 8 nach sonstigen zweckmäßigen Gesichtspunkten angeordnet werden kann. Als temperaturabhängiges Bauteil 9 bietet sich insbesondere ein NTC-Widerstand an, dessen elektrischer Widerstand sich in funktioneller Abhängigkeit von der Temperatur verändert. Der NTC-Widerstand 9 kann mittels Widerstandsdruck im wesentlichen mittels derselben Technologie wie die Leiterbahnen 15 auf der Beschichtung 13 der Leiterplatte 10 aufgebracht werden.

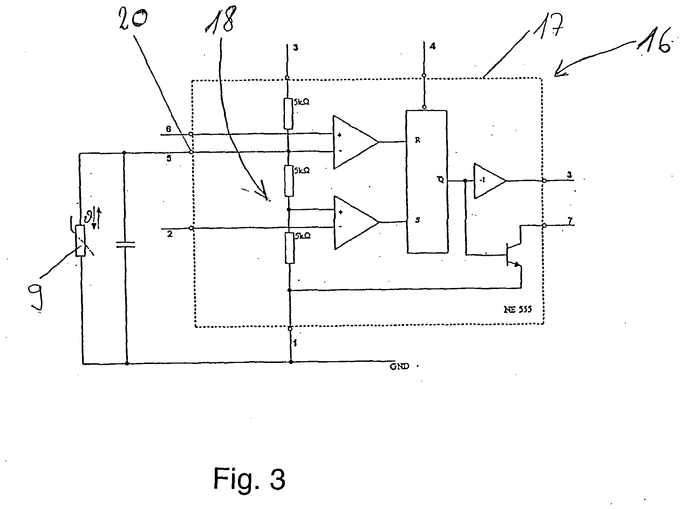

Bei einem mit Gleichspannung betriebenen Elektrowerkzeug bietet es sich an, daß die Schaltungsanordnung 6 als Pulsweiten-Modulations(PWM)-Schaltung 16 ausgebildet ist. Der Schaltplan für eine solche PWM-Schaltung 16 ist schematisch in Fig. 3 zu sehen. Die PWM-Schaltung 16 weist einen Timer-Baustein 17 als integrierte Schaltung auf. Beispielsweise kann es sich bei dem Timer-Baustein 17 um den bekannten Chip mit der Bezeichnung NE555 handeln. Dieser Timer-Baustein 17 besitzt einen internen Spannungsteiler 18. Zur Reduzierung der Leistung der Last kann nun in einfacher Art und Weise das Tastverhältnis der PWM-Schaltung 16 verkleinert werden. Bevorzugterweise ist zu diesem Zweck der externe NTC-Widerstand 9 über entsprechende Eingänge 20 des Timer-Bausteins 17 an den internen Spannungsteiler 18 angeschaltet.

Bei einem mit Wechselspannung betriebenen Elektrowerkzeug bietet es sich an, daß die Schaltungsanordnung 6 als Phasenanschnitt- und/oder Phasenabschnitt-Steuerungsschaltung ausgebildet ist, wobei das Leistungsbauteil 8 aus einen Triac o. dgl. besteht. Derartige Phasenanschnitt- und/oder Phasenabschnitt-Steuerungsschaltungen sind an sich bekannt, so daß diese nicht weiter gezeigt sind. Zur Reduzierung der Leistung der Last wird dann der Phasenanschnitt und/oder Phasenabschnitt dementsprechend verkleinert.

### Bezugszeichen-Liste:

- 1:: elektrischer Schalter
- 2:: Gehäuse
- 3:: Betätigungsorgan
- 4:: Betätigungselement
- 5:: Anschlußklemme
- 6:: Schaltungsanordnung
- 7:: Bauelement
- 8:: Leistungsbauteil
- 9:: Mittel zur Überwachung der Temperatur / temperaturabhängiges Bauteil / NTC-Widerstand
- 10:: Leiterplatte / IMS-Leiterplatte
- 11:: Metallteil
- 12:: Oberfläche (von Metallteil)
- 13:: (isolierende) Beschichtung (auf Metallteil)
- 14:: Halterung (für Leiterplatte)
- 15:: Leiterbahn
- 16:: Pulsweiten-Modulations-Schaltung
- 17:: Timer-Baustein
- 18:: Spannungsteiler (von Timer-Baustein)
- 19:: Kühlkörper
- 20:: Eingang (von Timer-Baustein)

## Patentansprüche

1. Elektrischer Schalter für ein Elektrowerkzeug mit einem Elektromotor, wie Akku und/oder Netz-Elektrowerkzeuge, mit einem Gehäuse (2), mit einem am Gehäuse (2) beweglich angeordneten Betätigungsorgan (3) für die manuelle Betätigung des Elektrowerkzeugs, mit einem im Gehäuse (2) befindlichen Kontaktsystem, und mit einer im Gehäuse (2) angeordneten, in der Art einer Leistungselektronik ausgebildeten elektrischen Schaltungsanordnung (6) zur Drehzahlsteuerung und/oder Drehzahlregelung des eine Last bildenden Elektromotors für das Elektrowerkzeug, wobei die elektrische Schaltungsanordnung (6) wenigstens ein wärmeerzeugendes Leistungsbauteil (8), wie einen Leistungstransistor, einen MOS-FET, einen Triac o. dgl., zur Steuerung und/ oder Regelung der Leistung der Last durch entsprechende Steuerung und/oder Regelung des durch das Leistungsbauteil (8) zur Last fließenden elektrischen Laststroms aufweist, wobei die Schaltungsanordnung (6) auf einer Leiterplatte (10) angeordnet ist, wobei ein Mittel (9) zur Überwachung der Temperatur der Schaltungsanordnung (6) vorhanden ist, wobei das Mittel (9) zur Überwachung der Temperatur ein temperaturabhängiges Bauteil aufweist, wobei das temperturabhängige Bauteil (9) auf der Leiterplatte (10) mit direkter Wärmekopplung zum Leistungsbauteil (8) angeordnet ist, und wobei das Mittel (9) zur Überwachung der Temperatur bei Erreichen einer Grenz-Temperatur eine Reduzierung der Leistung der Last mit Hilfe des Leistungsbauteils (8) durch Reduzierung des durch das Leistungsbauteil (8) fließenden Laststroms bewirkt.

2. Elektrischer Schalter nach Anspruch 1, **dadurch gekennzeichnet, dass** die Leistung der Last soweit reduziert wird, dass die Grenz-Temperatur anschließend wieder unterschritten wird.

3. Elektrischer Schalter nach Anspruch 1 oder 2, **dadurch gekennzeichnet, dass** es sich bei der Leiterplatte (10) um eine IMS (Insulated Metal Substrate)-Leiterplatte handelt.

4. Elektrischer Schalter nach Anspruch 1, 2 oder 3, **dadurch gekennzeichnet, dass** es sich bei dem temperaturabhängigem Bauteil (9) um einen NTC-Widerstand handelt, und dass vorzugsweise der NTC-Widerstand (9) mittels Widerstandsdruck auf die Leiterplatte (10) aufgebracht ist.

5. Elektrischer Schalter nach einem der Ansprüche 1 bis 4, **dadurch gekennzeichnet, dass** die Schaltungsanordnung (6) als Pulsweiten-Modulations(PWM)-Schaltung (16) ausgebildet ist, und dass vorzugsweise zur Reduzierung der Leistung der Last das Tastverhältnis der PWM-Schaltung. (16) verkleinert wird.

6. Elektrischer Schalter nach einem der Ansprüche 1 bis 5, **dadurch gekennzeichnet, dass** die PWM-Schaltung (16) einen Timer-Baustein (17) mit einem internen Spannungsteiler (18) aufweist, und dass vorzugsweise der NTC-Widerstand (9) an den internen Spannungsteiler (18) angeschaltet ist.

7. Elektrischer Schalter nach einem der Ansprüche 1 bis 6, **dadurch gekennzeichnet, dass** die Schaltungsanordnung (6) als Phasenanschnitt- und/oder Phasenabschnitt-Steuerungsschaltung ausgebildet ist, und dass vorzugsweise zur Reduzierung der Leistung der Last der Phasenanschnitt und/oder Phasenabschnitt verkleinert wird.

8. Elektrischer Schalter nach einem der Ansprüche 1 bis 7, **dadurch gekennzeichnet, daß** bei Erreichen der Grenz-Temperatur der Schaltungsanordnung (6) eine Drehzahlabsenkung vorgenommen wird.

## Claims

1. Electrical switch for a power tool with an electric motor, such as battery-operated and/or mains-operated power tools, having a housing (2) with an actuating member (3) arranged movably on the housing (2) for the manual actuation of the power tool, having a contact system being located within the housing (2) and having an electric switch arrangement (6) being arranged within the housing (2) and designed in the manner of a power electronic for speed control and/or speed regulation of the electric motor forming a load for the power tool, wherein the electric switch arrangement (6) has at least one heat-producing power component (8), such as a power transistor, an MOS-FET, a triac or similar, for the control and/or regulation of the power of the load by means of appropriate control and/or regulation of the electric load current flowing through the power component (8) to the load, wherein the switch arrangement (6) is arranged on a circuit board (10), wherein a means (9) exists for monitoring the temperature of the switch arrangement (6), wherein the means (9) for monitoring the temperature has a temperature-dependent component, wherein the temperature-dependent component (9) is arranged on the circuit board (10) with direct thermal coupling to the power component (8), and wherein the means (9) for monitoring the temperature upon reaching a threshold temperature effects a reduction of the power of the load with the help of the power component (8) by means of reducing the load current flowing through the power component (8).

2. The electrical switch according to claim 1, **characterised in that** the power of the load is so far reduced that the temperature then drops under threshold temperature again.

3. The electrical switch according to claim 1 or 2, **characterised in that** the circuit board (10) is an IMS (Insulated Metal Substrate) circuit board.

4. The electrical switch according to claim 1, 2 or 3, **characterised in that** the temperature-dependent component (9) is an NTC resister, and that preferably the NTC resistor (9) is attached to the circuit board (10) by means of resistance pressure.

5. The electrical switch according to one of claims 1 to 4, **characterised in that** the switch arrangement (6) is designed as a pulse-width modulation (PWM) switch (16), and that preferably the duty cycle of the PWM switch (16) is attenuated to reduce the power of the load.

6. The electrical switch according to one of claims 1 to 5, **characterised in that** the PWM switch (16) has a timer component (17) with an internal voltage divider (18), and that preferably the NTC resistor (9) is connected to the internal voltage divider (18).

7. The electrical switch according to one of claims 1 to 6, **characterised in that** the switch arrangement (6) is designed as a phase cut-on and/or phase cut-off control switch, and that preferably the phase cut-on and/or phase cut-off is attenuated to reduce the power of the load.

8. The electrical switch according to one of claims 1 to 7, **characterised in that** a speed reduction is effected upon reaching the threshold temperature of the switch arrangement (6).

## Revendications

1. Interrupteur électrique pour un outil électrique doté d'un moteur électrique, tel que des outils électriques sur secteur et ou à piles, comprenant un boîtier (2), un organe d'actionnement (3) monté mobile sur le boîtier (2) pour l'actionnement manuel de l'outil électrique, comprenant un système de contact se trouvant dans le boîtier (2), et comprenant une circuiterie (6) électrique conçue sous la forme d'une électronique de puissance, disposée dans le boîtier (2) pour commander et/ou régler la vitesse du moteur électrique formant une charge pour l'outil électrique, la circuiterie électrique (6) présentant au moins un composant de puissance (8) générant de la chaleur, tel qu'un transistor de puissance, un MOSFET, un thyristor bidirectionnel ou similaire pour commander et/ou réguler la puissance de la charge par la commande et/ou le réglage correspondant(e) du courant de charge électrique circulant par le composant de puissance (8) vers la charge, la circuiterie (6) étant disposée sur une carte de circuit imprimé (10), un moyen (9) de surveillance de la température de la circuiterie (6) étant prévu, le moyen (9) de surveillance de la température présentant un composant dépendant de la température, le composant (9) dépendant de la température étant disposé sur la carte de circuit imprimé (10) avec couplage thermique direct au composant de puissance (8), et le moyen (9) de surveillance de la température, lorsqu'une température limite est atteinte, réduit la puissance de la charge à l'aide du composant de puissance (8) par réduction du courant de charge circulant par le composant de puissance (8).

2. Interrupteur électrique selon la revendication 1, **caractérisé en ce que** la puissance de la charge est réduite jusqu'à ce que la température limite soit ensuite de nouveau devenue inférieure.

3. Interrupteur électrique selon la revendication 1 ou 2, **caractérisé en ce que** la carte de circuit imprimé (10) est une carte de circuit imprimé SMI (substrat métallique isolé).

4. Interrupteur électrique selon la revendication 1, 2 ou 3, **caractérisé en ce que** le composant (9) dépendant de la température est une thermistance CTN, et **en ce que** de préférence la thermistance CTN (9) est appliquée par pression de résistance sur la carte de circuit imprimé (10).

5. Interrupteur électrique selon l'une des revendications 1 à 4, **caractérisé en ce que** la circuiterie (6) est conçue sous la forme d'un circuit (16) de modulation de largeur d'impulsions (MLI) et **en ce que** de préférence pour réduire la puissance de la charge le facteur de réglage par impulsion du circuit MLI (16) est diminué.

6. Interrupteur électrique selon l'une des revendications 1 à 5, **caractérisé en ce que** le circuit MLI (16) présente un module minuteur (17) comprenant un diviseur de tension (18) interne et **en ce que** de préférence la thermistance CTN (9) est raccordée au diviseur de tension (18) interne.

7. Interrupteur électrique selon l'une des revendications 1 à 6, la circuiterie (6) est conçue sous la forme de circuit de commande à découpage de début de phase et / ou découpage de fin de phase, et en ce que de préférence pour réduire la puissance de la charge le découpage de début de phase et / ou découpage de fin de phase est diminuée.

8. Interrupteur électrique selon l'une des revendications 1 à 7, **caractérisé en ce que** lorsque la température limite de la circuiterie (6) est atteinte, la vitesse est réduite.
